# EUROPEAN PATENT SPECIFICATION

(11) **EP 3 406 444 B1**
(45) Date of publication and mention of the grant of the patent: **30.10.2019**
(21) Application number: 16886285.2
(22) Date of filing: 20.01.2016
(51) Int. Cl.: B41F 15/42, B41F 15/08, B41F 15/40, B41M 1/12, B41F 15/26, H05K 3/12

(54) **PRINTING DEVICE AND SUBSTRATE POSITION ADJUSTMENT METHOD**
DRUCKVORRICHTUNG UND VERFAHREN ZUR ANPASSUNG DER POSITION EINES SUBSTRATS
DISPOSITIF D'IMPRESSION ET PROCÉDÉ DE RÉGLAGE DE LA POSITION D'UN SUBSTRAT

(43) Date of publication of application: 28.11.2018
(73) Proprietor: Yamaha Hatsudoki Kabushiki Kaisha, Shizuoka-ken 438-8501 (JP)
(72) Inventor: TOTANI, Katsumi, Iwata-shi Shizuoka-ken 438-8501 (JP)
(74) Representative: Müller-Boré & Partner Patentanwälte PartG mbB
(86) International application number: PCT/JP2016/051510
(87) International publication number: WO 2017/126043

(56) References cited:
- WO-A1-2014/147812
- JP-A- H0 444 848
- JP-A- H0 444 848
- JP-A- H1 041 618
- JP-A- H11 227 157
- JP-A- 2015 182 231
- JP-A- 2015 182 231

## Description

### [TECHNICAL FIELD]

The present invention relates to a printing technique of printing paste on the upper surface of a mask onto a board by causing a squeegee to slide on the upper surface of the mask overlapping the board from above.

### [BACKGROUND]

A conventional printer of printing paste onto a board using a mask is equipped with a mechanism for adjusting the height of the board relative to the mask. In a screen printer described in patent literature 1, for example, when a conveyor transports a board into a position above a backup pin, the backup pin moves up to receive the board from the conveyor. Further, a board up-and-down mechanism supporting the backup pin moves up together with the backup pin to move up the board to the height of the mask, thereby bringing the board into contact with the lower surface of the mask. Thus, by causing a squeegee to slide on the upper surface of the mask, cream solder on the upper surface of the mask can be printed appropriately onto the board.

### [CITATION LIST]

### [PATENT LITERATURE]

[PTL1] WO2014/147812

JP 2015 182231 A discloses a printer and a method that controls a printing pressure against a mask of a printing head part according to the preamble of claims 1 and 5.

JP H10 41618 A discloses a squeegee which consists of a first member constituted of an elastic member like urethane rubber, and a second member which is stacked on the opposite side of the printed surface of the first member and has rigidity larger than that of the first member.

### [SUMMARY]

### [TECHNICAL PROBLEM]

Meanwhile, there has actually been a situation where, due to an inappropriate upward movement range of the board, a gap is formed between the board and the mask, or the mask is lifted by the board to be bowed upward. These have occurred for reason of erroneous setting of an upward movement range of the board by an operator or change in thickness of the board between lots, for example. Such an inappropriate height of the board relative to the mask has made it difficult to print paste onto the board favorably.

The present invention has been made in view of the above-described problem, and is intended to provide a technique allowing appropriate adjustment of the height of a board relative to a mask.

### [SOLUTION TO PROBLEM]

A printer according to the invention is defined in claim 1. Further preferred embodiments of the printer are defined in claims 2-4.

A board position adjusting method according to the invention is defined in claim 5.

### [ADVANTAGEOUS EFFECTS OF INVENTION]

In the present invention, detected is a pressure received by the squeegee brought into contact with the first area of the upper surface of the mask, the first area being faced by the board. Specifically, if the position of the board is not appropriate relative to the mask, a gap may be formed between the mask and the board or the mask may be bowed upward as described above, thereby affecting a pressure to be received by the squeegee contacting the first area of the mask. In response, in the present invention, by the use of correlation between the position of the board relative to the mask and a pressure acting on the squeegee, the position of the board relative to the mask is adjusted in the vertical direction based on the pressure received by the squeegee. As a result, the position of the board relative to the mask can be adjusted appropriately in the vertical direction.

### [BRIEF DESCRIPTION OF DRAWINGS]

Fig. 1 is a front view schematically showing a printer to which the present invention is applied.
Fig. 2 is a block diagram showing electrical structures provided in the printer of Fig. 1.
Fig. 3 is a side view schematically showing the squeegee unit.
Fig. 4 is a front view schematically showing the squeegee unit.
Fig. 5 is a side view schematically showing the operation of the squeegee unit.
Fig. 6 is a front view schematically showing the position of the height of the lower surface of the mask and the position of the height of the upper surface of the board relative to each other.
Fig. 7 is a flowchart showing a first example of the board height correction process according to the invention.
Fig. 8 is a timing chart schematically showing operation to be performed based on the flowchart of Fig. 7.
Fig. 9 is a flowchart showing a second example of the board height correction process not covered by the claims.
Fig. 10 is a timing chart schematically showing operation to be performed based on the flowchart of Fig. 9.
Fig. 11 is a flowchart showing a third example of the board height correction process not covered by the claims.
Fig. 12 is a timing chart schematically showing operation to be performed based on the flowchart of Fig. 10.

### [DESCRIPTION OF EMBODIMENT]

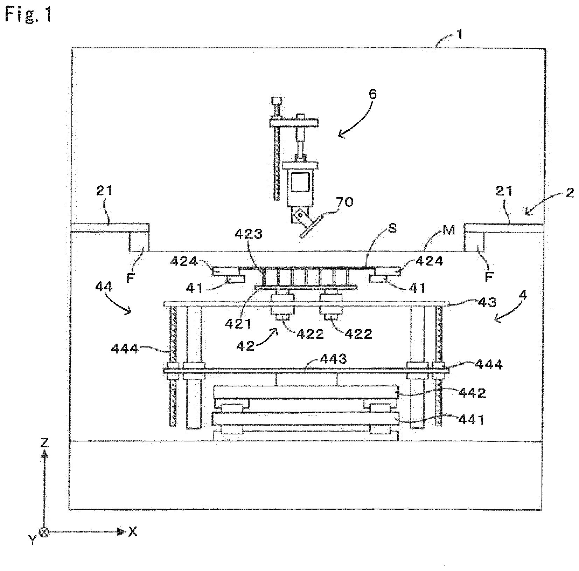

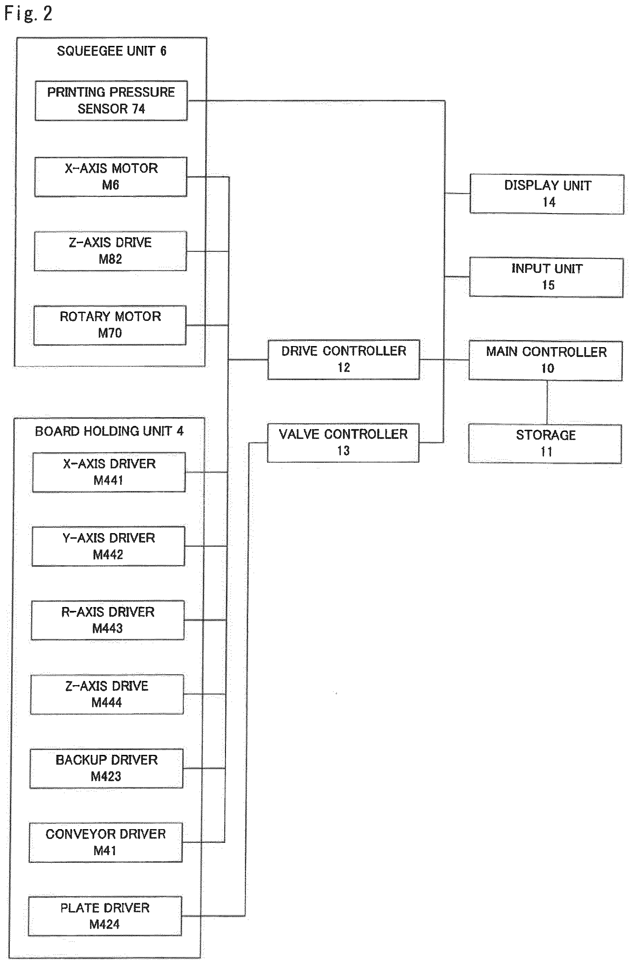

Fig. 1 is a front view schematically showing a printer to which the present invention is applied. Fig. 2 is a block diagram showing electrical structures provided in the printer of Fig. 1. Where appropriate, an XYZ orthogonal coordinate system defining a vertical direction by a Z direction and horizontal directions by an X direction and a Y direction is shown in Fig. 1 and drawings referred to below. The printer 1 includes a mask holding unit 2 that holds a mask M, a board holding unit 4 arranged below the mask M, and a squeegee unit 6 arranged above the mask M. The printer 1 further includes a main controller 10 constructed of a central processing unit (CPU) and a random access memory (RAM), for example, and a storage 11 constructed of a hard disk drive (HDD), for example. The main controller 10 controls each of the units 4 and 6 by following a printing program stored in the storage 11, thereby causing the tip of a squeegee 70 of the squeegee unit 6 to slide on the upper surface of the mask M in the X direction while causing a board S to face the mask M from below using the board holding unit 4 (printing operation). In this way, solder supplied to the upper surface of the mask M is printed onto the upper surface of the board S via a pattern hole penetrating the mask M.

The printer 1 includes a drive controller 12 and a valve controller 13 that control the operations of movable parts in the device, the main controller 10 controls the movable parts in the units 4 and 6 using the drive controller 12 and the valve controller 13. The printer 1 further includes a display unit 14 constructed of a liquid crystal display, for example, and an input unit 15 constructed of input equipment such as a keyboard or a mouse. Thus, an operator is allowed to determine the operating situation of the printer 1 by checking an indication on the display unit 14 and input a command to the printer 1 by operating the input unit 15. The display unit 14 and the input unit 15 may be constructed integrally as a touch panel.

The mask holding unit 2 includes a clamp member 21. The mask M is attached in a removable fashion to the clamp member 21 through a frame F provided at the periphery of the mask M. By doing so, the mask M having a flat-plate shape is held horizontally by the mask holding unit 2. The mask M has a rectangular shape in a plan view and has a through hole (pattern hole) of a shape corresponding to a printing pattern to be formed on the board S.

The board holding unit 4 is arranged below the mask M held by the mask holding unit 2 and fulfills the function of adjusting the position of the board S relative to the mask M. The board holding unit 4 includes conveyors 41 in a pair that transport the board S, a board holder 42 that holds the board S received from the conveyors 41, and a movable table 43 of a flat-plate shape that supports the conveyors 41 and the board holder 42.

The conveyors 41 in a pair are separated in the X direction, arranged parallel to the Y direction, and support the opposite ends of the board S in the X direction from below on the respective upper surfaces of the conveyors 41. The board holding unit 4 includes a conveyor driver M41 that drives the conveyors 41. If the conveyor driver M41 having received a command from the drive controller 12 drives each conveyor 41, each conveyor 41 transports the board S in the Y direction to transport the board S into or out of the printer 1.

The board holder 42 includes an up-down table 421 of a flat-plate shape, and a slide support column 422 slidable in the Z direction relative to the movable table 43. The up-down table 421 is supported on the upper end of the slide support column 422. The up-down table 421 has an upper surface on which multiple backup pins 423 standing upright in the Z direction are aligned and spaced at intervals in the X direction and the Y direction. The board holder 42 further includes a backup driver M423. If the backup driver M423 having received a command from the drive controller 12 moves up or down the slide support column 422, the backup pins 423 are moved up or down together with the up-down table 421. During incoming transport of the board S by the conveyors 41, for example, the backup driver M423 locates the upper end of each backup pin 423 below the upper surfaces of the conveyors 41. When the conveyors 41 transport the board S into a position directly above the backup pins 423, the backup driver M423 moves up the backup pins 423 to make the upper ends of the backup pins 423 project upward from the upper surfaces of the conveyors 41. By doing so, the board S is transferred from the upper surfaces of the conveyors 41 to the upper end of each backup pin 423.

The board holder 42 includes clamp plates 424 in a pair arranged above the conveyors 41 in a pair and separated in the X direction, and a plate driver M424 that drives at least one of the clamp plates 424 in the X direction. The respective upper surfaces of the clamp plates 424 are planes parallel to the X direction and the Y direction and are located at the same height. The plate driver M424 opens and closes a valve in response to a command from the valve controller 13, thereby adjusting air to be supplied to the clamp plate 424. By doing so, the clamp plate 424 is driven in the X direction.

The drive controller 12 moves up the board S on the backup pins 423 to a position between the clamp plates 424 in a pair, and the valve having received a command from the valve controller 13 operates to reduce an interval between the clamp plates 424, thereby clamping the board S with the clamp plates 424 from the X direction (horizontal direction). More specifically, the storage 11 stores board height control data showing a value of drive by the backup driver M423 for making a match between the height of the upper surface of the board S and the height of the upper surface of the clamp plate 424. If the backup driver M423 is an actuator that drives the slide support column 422, for example, the stored board height control data can be the position of an actuator rod (drive value) at which the height of the upper surface of the board S and the height of the upper surface of the clamp plate 424 match each other. Alternatively, if the backup driver M423 is a motor that drives the slide support column 422, the stored board height control data can be the rotary angle of the motor (drive value) at which the height of the upper surface of the board S and the height of the upper surface of the clamp plate 424 match each other. The board height control data is stored in advance into the storage 11 through operation by an operator on the input unit 15, for example. The backup driver M423 moves up the board S by an upward movement range indicated by the board height control data. While the board S is moved up by the backup driver M423, the plate driver M424 maintains an interval between the clamp plates 424 in a pair greater than the width of the board S in the X direction. When the backup driver M423 finishes moving up the board S, the plate driver M424 reduces the interval between the clamp plates 424 in a pair to clamp the board S with these clamp plates 424 from the X direction. In this way, the board S is clamped with the clamp plates 424.

The board holding unit 4 further includes a table drive mechanism 44 that drives the movable table 43. The table drive mechanism 44 includes an X-axis table 441, a Y-axis table 442 attached to the upper surface of the X-axis table 441, an R-axis table 443 attached to the upper surface of the Y-axis table 442, and a ball screw 444 which moves up and down the movable table 43 relative to the R-axis table 443. The table drive mechanism 44 further includes an X-axis driver M441 that drives the X-axis table 441 in the X direction, a Y-axis driver M442 that drives the Y-axis table 442 in the Y direction, an R-axis driver M443 that drives the R-axis table 443 in an R direction (direction of rotation about an axis parallel to the Z direction), and a Z-axis driver M444 that drives the movable table 43 in the Z direction by rotating the ball screw 444. Thus, the conveyor 41 and the board holder 42 arranged at the movable table 43 can be driven in the X, Y, Z, and R directions in response to control over each of the drivers M441 to M444 by the drive controller 12. For determining the position of the incoming board S relative to the mask M, for example, the drive controller 12 adjusts the position of the board S clamped by the clamp plates 424 within an XY plane using the X-axis, Y-axis, and R-axis drivers M441, M442, and M443 and in the Z direction using the Z-axis driver M444. By doing so, the respective upper surfaces of the clamp plates 424 and the board S are brought into contact with the lower surface of the mask M.

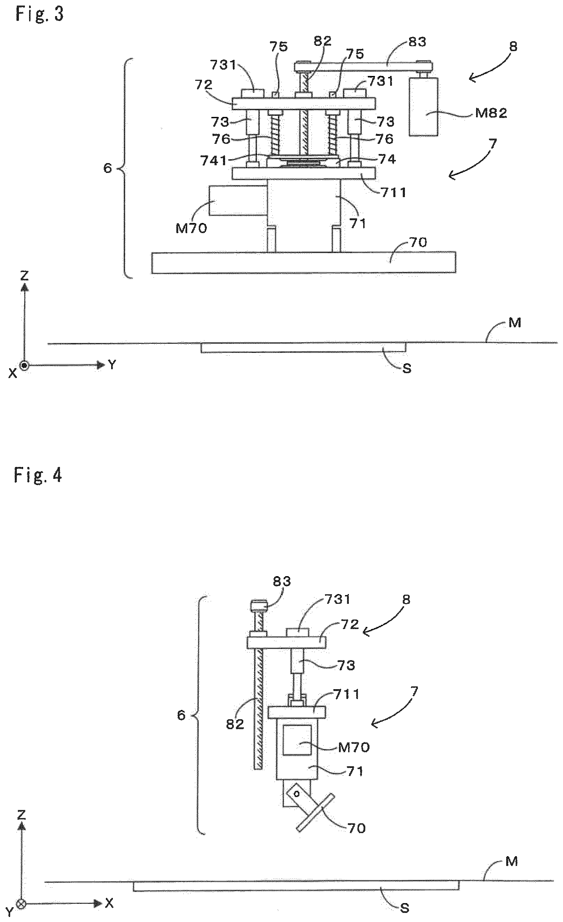

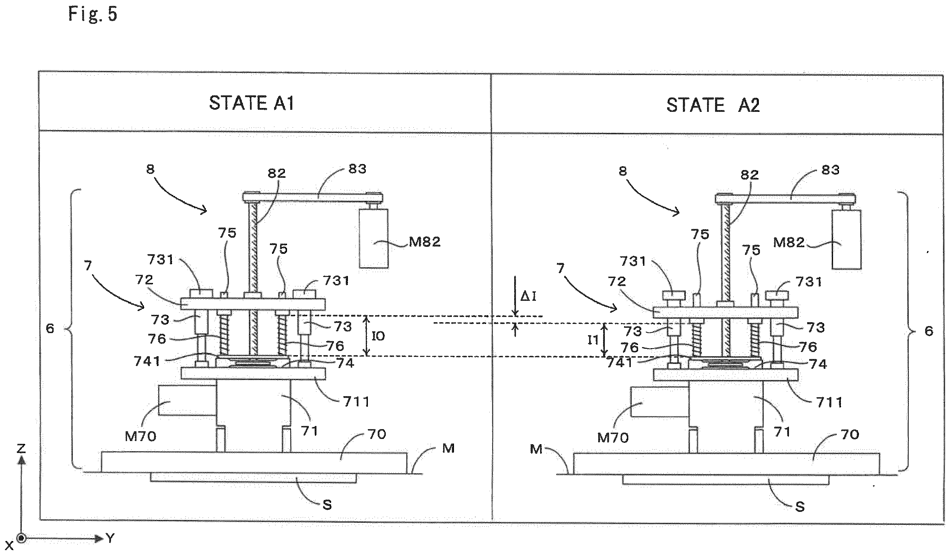

The squeegee unit 6 will be described in detail next by further referring to Figs. 3 to 5. Fig. 3 is a side view schematically showing the squeegee unit. Fig. 4 is a front view schematically showing the squeegee unit. Fig. 5 is a side view schematically showing the operation of the squeegee unit. The squeegee unit 6 is arranged above the mask M held by the mask holding unit 2. The squeegee unit 6 includes a printing head 7 with the squeegee 70, and a head drive mechanism 8 that drives the printing head 7 in the X direction and the Z direction.

The printing head 7 includes a support bracket 71 by which the squeegee 70 is supported so as to be rotatable about an axis parallel to the Y direction, and a rotary motor M70 attached to the support bracket 71. The rotary motor M70 is connected to the rotary axis of the squeegee 70. The drive controller 12 can adjust an angle (attack angle) at which the squeegee 70 contacts the mask M by rotating the squeegee 70 using the rotary motor M70.

The printing head 7 includes a support frame 72 arranged above the support bracket 71 and supporting the support bracket 71 to which the squeegee 70 is attached. Specifically, the printing head 7 includes two support rods 73 extending parallel to the Z direction. Each support rod 73 is provided so as to be slidable in the Z direction relative to the support frame 72. The support frame 72 has an insertion hole provided for each support rod 73 and penetrating the support frame 72 in the Z direction. The two support rods 73 are inserted from above into corresponding insertion holes. Each support rod 73 has an upper end where a flange 731 having a larger diameter than the insertion hole is formed. The support rod 73 is configured in such a manner that the flange 731 gets snagged on the support frame 72 from above to prevent the support rod 73 from falling off the support frame 72. The lower ends of the two support rods 73 are attached to the upper surface of a plate 711 forming the upper end of the support bracket 71. In this way, the support frame 72 supports the squeegee 70 provided below the support frame 72 so as to allow movement of the squeegee 70 in the Z direction.

The printing head 7 has the mechanism of applying a printing pressure to the squeegee 70 and detecting the printing pressure. Specifically, the printing head 7 includes a printing pressure sensor 74 attached to the upper surface of the plate 711 of the support bracket 71, and a plate 741 attached to the upper surface of the printing pressure sensor 74. The printing pressure sensor 74 is constructed of a load cell, for example. The printing head 7 includes two guide rods 75 extending parallel to the Z direction and slidable in the Z direction relative to the support frame 72, and a compression spring 76 fitted externally to each guide rod 75. The support frame 72 has an insertion hole provided for each guide rod 75 and penetrating the support frame 72 in the Z direction. The lower end of each guide rod 75 inserted from above into a corresponding insertion hole is attached to the upper surface of the plate 741. Each compression spring 76 is fitted externally to the guide rod 75 projecting downward from the support frame 72. The upper end of the compression spring 76 abuts on the support frame 72 from below and the lower end of the compression spring 76 abuts on the plate 741 from above. The compression spring 76 provided between the support frame 72 and the plate 741 in this way generates biasing force to increase in response to reduction in an interval between the support frame 72 and the support plate 741. As a result, the plate 741, the printing pressure sensor 74, the support bracket 71, and the squeegee 70 are biased by the biasing force of the compression spring 76 in a direction away from the support frame 72, specifically, biased downward. The biasing force of the compression spring 76 is transmitted through the printing pressure sensor 74 to the squeegee 70. This allows the main controller 10 to check biasing force applied to the squeegee 70 based on a result of detection by the printing pressure sensor 74.

The head drive mechanism 8 includes a ball screw 82 extending in the Z direction, a Z-axis motor M82, and an endless belt 83 that transmits output from the Z-axis motor M82 to the ball screw 82. The support frame 72 is attached to a nut of the ball screw 82 and is moved up and down by the rotation of the ball screw 82. Thus, the drive controller 12 can adjust the height of the support frame 72 by controlling the rotary angle of the Z-axis motor M82. The head drive mechanism 8 further includes an X-axis motor M6 that drives the configuration of the squeegee unit 6 shown in Figs. 3 and 4 integrally in the X direction. Thus, the drive controller 12 can perform the printing operation by moving the squeegee 70 in the X direction using the X-axis motor M6 while moving down the support frame 72 to bring the squeegee 70 into contact the upper surface of the mask M using the Z-axis motor M82.

In the squeegee unit 6 having the foregoing configuration, a predetermined printing pressure can be applied to the squeegee 70 by adjusting the height of the support frame 72. This will be described by referring to Fig. 5. If the support frame 72 is moved down while the squeegee 70 is separated from and above the mask M, the squeegee 70 is brought into contact with the mask M at some point in time as shown in a state A1 of Fig. 5. In this state, the flange 731 of the support rod 73 contacts the support frame 72 and the support frame 72 and the plate 741 are placed at an interval 10 corresponding to the natural length of the compression spring 76 or slightly shorter than the natural length. If the support frame 72 in the state A1 is moved down thereafter, the support frame 72 and the plate 741 are placed at an interval 11 reduced from the interval 10 by a downward movement range ΔI of the support frame 72 (state A2 of Fig. 5). As a result, the compression spring 76 is compressed by the downward movement range ΔI, and a pressure responsive to biasing force determined by multiplying the downward movement range ΔI by the spring constant of the compression spring 76 is applied as a printing pressure to the squeegee 70. More specifically, a pressure corresponding to the sum of the biasing force of the compression spring 76 and the weight of a part of the printing head 7 itself supported by the support frame 72 is applied as a printing pressure to the squeegee 70.

As described above, a printing pressure responsive to the height of the support frame 72 is applied to the squeegee 70. Thus, the drive controller 12 can adjust a printing pressure to be applied to the squeegee 70 during the printing operation by controlling the height of the support frame 72 using the Z-axis motor M82. The storage 11 stores printing pressure control data showing a drive value of the Z-axis motor M82 for locating the support frame 72 at a height (printing pressure application height hp) at which an intended printing pressure is applied to the squeegee 70. During implementation of the printing operation, if the Z-axis motor M82 makes drive by a drive value indicated by the printing pressure control data, the support frame 72 is located at the printing pressure application height hp. More specifically, the stored printing pressure control data can be the rotary angle of the Z-axis motor M82 (drive value) for locating the support frame 72 at a height at which the compression spring 76 generates biasing force corresponding to the intended printing pressure. Alternatively, if the support frame 72 is to be moved up and down by an actuator, the stored printing pressure control data can be the position of a rod of the actuator (drive value) for locating the support frame 72 at a height at which the compression spring 76 generates biasing force corresponding to the intended printing pressure.

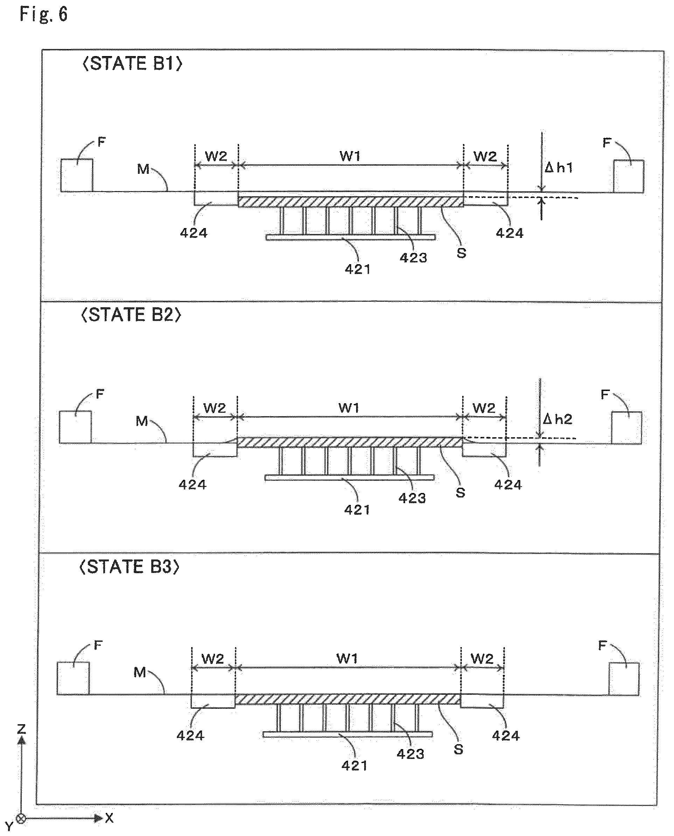

Meanwhile, there has been a situation where, due to an inappropriate relationship between the height of the lower surface of the mask M held by the mask holding unit 2 and the height of the upper surface of the board S held by the board holding unit 4, a printing pressure applied to the squeegee 70 deviates from the intended printing pressure even with the support frame 72 located at a height indicated by the printing pressure control data. This will be described by referring to Fig. 6.

Fig. 6 is a front view schematically showing the position of the height of the lower surface of the mask and the position of the height of the upper surface of the board relative to each other. Fig. 6 shows a board facing area W1 of the upper surface of the mask M where the board S faces the mask M from below, and a plate facing area W2 of the upper surface of the mask M where the clamp plate 424 faces the mask M from below. In each of a state B1, a state B2, and a state B3 of Fig. 6, the upper surface of each clamp plate 424 is at the same height as the lower surface of the mask M held by the mask holding unit 2.

In the state B1 of Fig. 6, the upper surface of the board S is below the upper surface of the clamp plate 424. As a result, a gap is formed between the mask M and the board S. In the state B1, if the squeegee 70 is pressed against the board facing area W1 while the support frame 72 is located at a height indicated by the printing pressure control data, the mask M having flexibility is depressed downward by a range Δh1 of the gap until a part of the lower surface of the mask M facing the tip of the squeegee 70 is brought into contact with the board S. This increases an interval between the support frame 72 and the squeegee 70, specifically, the length of the compression spring 76 by the range Δh1, so that a printing pressure applied to the squeegee 70 is reduced to become lower than the intended printing pressure. This reduction in the printing pressure corresponds to biasing force determined by multiplying the spring constant of the compression spring 76 by the range Δh1.

In the state B2 of Fig. 6, the upper surface of the board S is above the upper surface of the clamp plate 424. As a result, the board facing area W1 of the mask M is bowed upward compared to the plate facing area W2. In the state B2, if the squeegee 70 is pressed against the board facing area W1 while the support frame 72 is located at a height indicated by the printing pressure control data, the board S supports the board facing area W1 in the upward bowed position against the printing pressure to prohibit downward movement of the squeegee 70 by a range Δh2 of the upward bowing. This reduces an interval between the support frame 72 and the squeegee 70, specifically, the length of the compression spring 76 by the range Δh2, so that a printing pressure applied to the squeegee 70 is increased to become higher than the intended printing pressure. This increase in the printing pressure corresponds to biasing force determined by multiplying the spring constant of the compression spring 76 by the range Δh2.

In the state B3 of Fig. 6, the upper surface of the clamp plate 424 and the upper surface of the board S are at the same height. As a result, the board facing area W1 and the plate facing area W2 of the mask M are located at the same height and the board facing area W1 of the mask M is supported by the board S. Thus, by pressing the squeegee 70 against the board facing area W1 while locating the support frame 72 at a height indicated by the printing pressure control data, the intended printing pressure can be applied to the squeegee 70.

As described above, a relationship between the height of the lower surface of the mask M held by the mask holding unit 2 and the height of the upper surface of the board S held by the board holding unit 4 affects a printing pressure to be applied to the squeegee 70. In this regard, the main controller 10 performs board height correction process of correcting the height of the board S relative to the mask M based on a result of detection of a printing pressure applied to the squeegee 70 while the support frame 72 is located at the printing pressure application height hp.

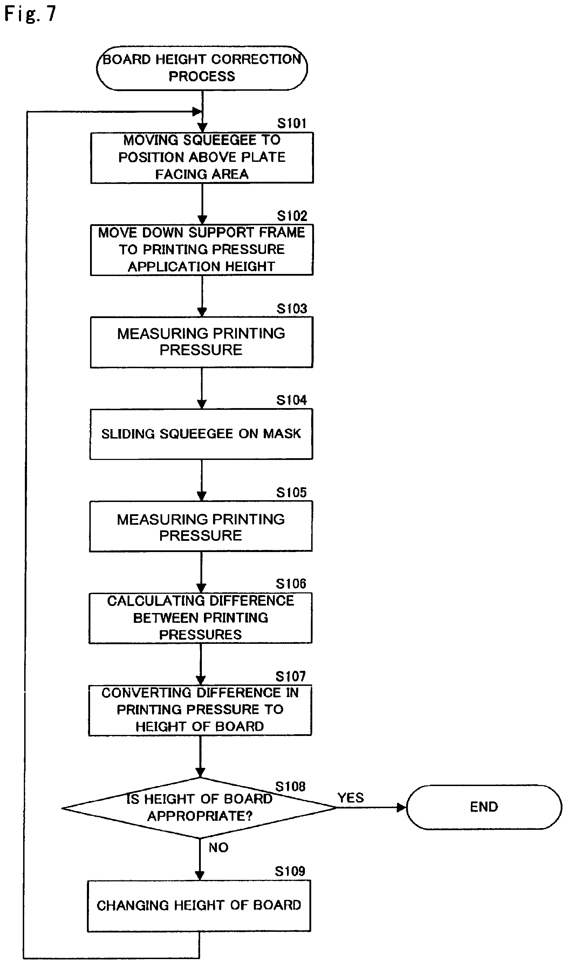

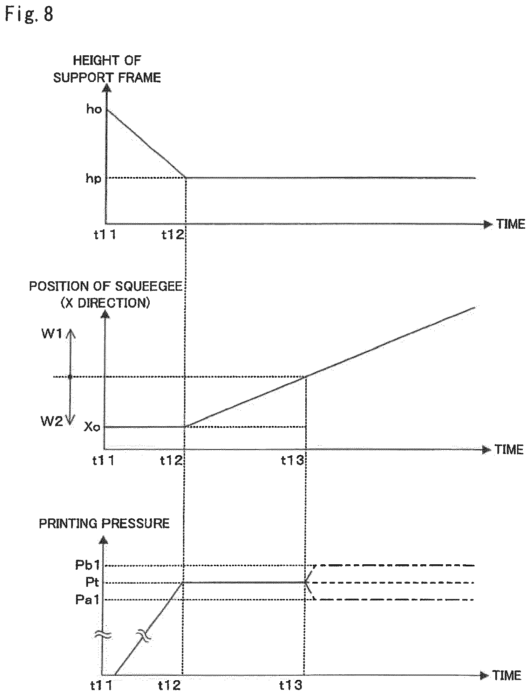

Fig. 7 is a flowchart showing a first example of the board height correction process of the invention. Fig. 8 is a timing chart schematically showing operation to be performed based on the flowchart of Fig. 7. When the board height correction process is started, the squeegee unit 6 moves the squeegee 70 to a position above the plate facing area W2 of the mask M while maintaining the support frame 72 at an initial height ho in step S101 (time t11). By doing so, the tip of the squeegee 70 in the X direction is located at an initial position Xo within the plate facing area W2. While the support frame 72 is at the initial height ho, the tip of the squeegee 70 is separated from and above the plate facing area W2 of the mask M. Next, the squeegee unit 6 moves down the support frame 72 from the initial height ho to the printing pressure application height hp (step S102). This causes the support frame 72 to reach the printing pressure application height hp at time t12 to press the squeegee 70 against the plate facing area W2 of the mask M. Then, the main controller 10 measures a printing pressure applied to the squeegee 70 based on output from the printing pressure sensor 74 (step S103). At this time, the clamp plate 424 contacting the lower surface of the mask M supports the plate facing area W2 against the printing pressure applied to the squeegee 70. Thus, the measured printing pressure is an intended printing pressure Pt.

Next, the squeegee unit 6 moves the squeegee 70 parallel to the X direction in conjunction with the support frame 72 while maintaining the support frame 72 at the printing pressure application height hp, thereby causing the tip of the squeegee 70 to slide on the upper surface of the mask M (step S104). Then, after time tl3 when the squeegee 70 reaches a boundary between the plate facing area W2 and the board facing area W1 adjacent to each other in the X direction, the main controller 10 measures a printing pressure applied to the squeegee 70 based on output from the printing pressure sensor 74 (step S105). At this time, if the position of the mask M and that of the board S are in the relationship shown as the state B1 of Fig. 6, the measured printing pressure is a printing pressure Pa1 lower than the intended printing pressure Pt (indicated by alternate long and short dashed lines in the graph of Fig. 8 showing a printing pressure). If the position of the mask M and that of the board S are in the relationship shown as the state B2 of Fig. 6, the measured printing pressure is a printing pressure Pb1 higher than the intended printing pressure Pt (indicated by alternate long and two short dashed lines in the graph of Fig. 8 showing a printing pressure). If the position of the mask M and that of the board S are in the relationship shown as the state B3, the measured printing pressure is equal to the intended printing pressure Pt (indicated by broken lines in the graph of Fig. 8 showing a printing pressure).

The main controller 10 calculates a difference between the printing pressure measured in step S103 and the printing pressure measured in step S105 (step S106). Based on a given conversion table, the main controller 10 converts this difference in printing pressure to the height of the upper surface of the board S (step S107). This conversion table has been given from a result of experiment conducted in advance for measuring a difference in printing pressure by changing the height of the upper surface of the board S while locating the support frame 72 at the printing pressure application height hp, and is stored in the storage 11. In step S108, the main controller 10 determines the appropriateness of the height of the upper surface of the board S by determining whether the height of upper surface of the board S is within a predetermined range.

If the height of the upper surface of the board S is not within the predetermined range (if "NO" in step S108), the main controller 10 changes the height of the board S (step S109). More specifically, after releasing clamp of the board S with the clamp plates 424, the main controller 10 moves up and down the backup pins 423 using the backup driver M423 to change the height of the board S. Then, the main controller 10 clamps the board S with the clamp plates 424 again. At this time, if the printing pressure actually measured in step S105 is lower than the intended printing pressure Pt, the main controller 10 moves up the board S. If the printing pressure actually measured in step S105 is higher than the intended printing pressure Pt, the main controller 10 moves down the board S. Step S101 to step S109 are performed repeatedly until the height of the upper surface of the board S is determined to be within the predetermined range in step S108. If the height of the upper surface of the board S is finally determined to be within the predetermined range in step S108, the board height correction process of Fig. 7 is finished.

As described above, in the first example of the board height correction process, detected is a printing pressure received by the squeegee 70 brought into contact with the board facing area W1 of the upper surface of the mask M to which the board S faces. Specifically, if the height of the board S is not appropriate relative to the mask M, a gap may be formed between the mask M and the board S or the mask M may be bowed upward as described above, thereby affected is a printing pressure to be received by the squeegee 70 contacting the board facing area W1 of the mask M. In response, by the use of correlation between the height of the board S relative to the mask M and a printing pressure acting on the squeegee 70, the height of the board S relative to the mask M is adjusted based on the printing pressure received by the squeegee 70. As a result, the height of the board S can be adjusted appropriately relative to the mask M.

The squeegee 70 is supported by the support frame 72 so as to be capable of moving up and down. The compression spring 76 biases the squeegee 70 downward by generating biasing force between the support frame 72 and the squeegee 70, the biasing force being to change in response to a difference in height between the support frame 72 and the squeegee 70. While the tip of the squeegee 70 contacts the upper surface of the mask M, the Z-axis motor M82 presses the support frame 72 downward against the biasing force of the compression spring 76 to press the tip of the squeegee 70 against the upper surface of the mask M with a printing pressure responsive to this biasing force. In this configuration, if the height of the board S is not appropriate relative to the mask M, affected is a printing pressure to be applied from the compression spring 76 to the squeegee 70 contacting the board facing area W1 of the mask M. In response, the main controller 10 adjusts the height of the board S relative to the mask M based on a result of detection of a printing pressure received by the squeegee 70 pressed against the board facing area W1 by the printing pressure sensor 74. By doing so, it becomes possible to adjust the height of the board S appropriately relative to the mask M.

In this first example of the board height correction process of the invention, performed is pressure detecting operation of causing the squeegee 70 to slide on the board facing area W1 of the mask M by moving the support frame 72 in the X direction (horizontal direction) after locating the support frame 72 at the printing pressure application height hp and pressing the squeegee 70 against the plate facing area W2 of the mask M (steps S102, S104). At this time, the plate facing area W2 is supported by the clamp plate 424 contacting the mask M from below, so that the height of the squeegee 70 pressed against the plate facing area W2 is stabilized independently of the position of the board S relative to the mask M. Meanwhile, the height of the squeegee 70 sliding on the board facing area W1 is changed by the position of the board S relative to the mask M. Specifically, if there is a gap between the mask M and the board S, the board facing area W1 is depressed by the pressing with the squeegee 70. Hence, the height of the squeegee 70 sliding on the board facing area W1 becomes lower than the height of the squeegee 70 pressed against the plate facing area W2. Conversely, if the mask M is bowed upward, the height of the squeegee 70 sliding on the board facing area W1 becomes higher than the height of the squeegee 70 pressed against the plate facing area W2. Thus, if the height of the board S is not appropriate relative to the mask M, an interval between the squeegee 70 and the support frame 72 changes between a period in which the squeegee 70 is pressed against the plate facing area W2 (a period before the time t13) and a period in which the squeegee 70 slides on the board facing area W1 (a period after the time tl3). As a result, a printing pressure to be applied to the squeegee 70 is also changed. In response, based on a difference between a printing pressure received by the squeegee 70 pressed against the plate facing area W2 and a printing pressure received by the squeegee 70 sliding on the board facing area W1, the main controller 10 adjusts the height of the board S relative to the mask M. By doing so, it becomes possible to adjust the height of the board S appropriately relative to the mask M.

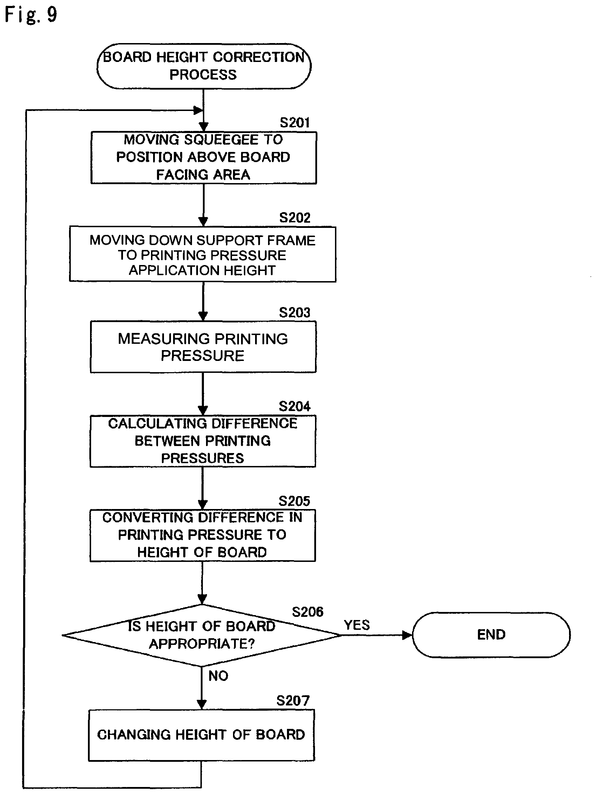

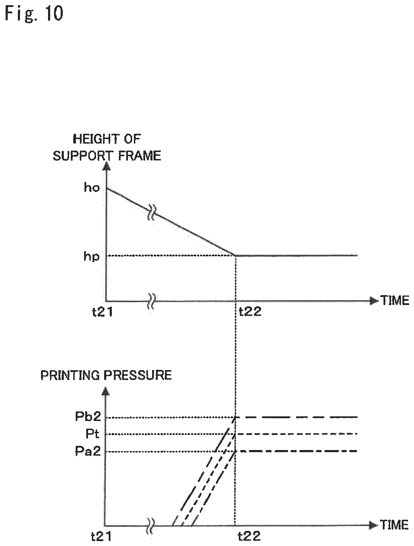

Fig. 9 is a flowchart showing a second non-claimed example of the board height correction process. Fig. 10 is a timing chart schematically showing operation to be performed based on the flowchart of Fig. 9. The following description is mainly intended for differences from the foregoing embodiment. If appropriate, description of common points will be omitted. Meanwhile, it should be noted that, by the presence of configurations common to those of the foregoing embodiment, effects comparable to those of the foregoing embodiment will certainly be achieved.

When the board height correction process is started, the squeegee unit 6 moves the squeegee 70 to a position above the board facing area W1 of the mask M while maintaining the support frame 72 at the initial height ho in step S201 (time t21). While the support frame 72 is at the initial height ho, the tip of the squeegee 70 is separated from and above the board facing area W1 of the mask M. Next, the squeegee unit 6 moves down the support frame 72 from the initial height ho to the printing pressure application height hp (step S202). This causes the support frame 72 to reach the printing pressure application height hp at time t22 to press the squeegee 70 against the board facing area W1 of the mask M. Then, the main controller 10 measures a printing pressure applied to the squeegee 70 based on output from the printing pressure sensor 74 (step S203). At this time, if the position of the mask M and that of the board S are in the relationship shown as the state B1 of Fig. 6, the measured printing pressure is a printing pressure Pa2 lower than the intended printing pressure Pt (indicated by alternate long and short dashed lines in the graph of Fig. 10 showing a printing pressure). If the position of the mask M and that of the board S are in the relationship shown as the state B2 of Fig. 6, the measured printing pressure is a printing pressure Pb2 higher than the intended printing pressure Pt (indicated by alternate long and two short dashed lines in the graph of Fig. 10 showing a printing pressure). If the position of the mask M and that of the board S are in the relationship shown as the state B3, the measured printing pressure is equal to the intended printing pressure Pt (indicated by broken lines in the graph of Fig. 10 showing a printing pressure).

The main controller 10 calculates a difference between the intended printing pressure Pt stored in advance in the storage 11 and the printing pressure measured in step S203 (step S204). Based on the foregoing conversion table, the main controller 10 converts this difference in printing pressure to the height of the upper surface of the board S (step S205). Next, in step S206, the main controller 10 determines the appropriateness of the height of the upper surface of the board S by determining whether the height of the upper surface of the board S is within a predetermined range. If the height of the upper surface of the board S is not within the predetermined range (if "NO" in step S206), the main controller 10 changes the height of the board S (step S207) like in step S109 described above. Step S201 to step S207 are performed repeatedly until the height of the upper surface of the board S is determined to be within the predetermined range in step S206. If the height of the upper surface of the board S is finally determined to be within the predetermined range in step S206, the board height correction process of Fig. 9 is finished.

As described above, in the second example of the board height correction process, detected is a printing pressure received by the squeegee 70 brought into contact with the board facing area W1 of the upper surface of the mask M to which the board S faces. By the use of correlation between the height of the board S relative to the mask M and a printing pressure acting on the squeegee 70, the height of the board S relative to the mask M is adjusted based on the printing pressure received by the squeegee 70. As a result, the height of the board S can be adjusted appropriately relative to the mask M.

In particular, in the second example of the board height correction process, performed is pressure detecting operation of locating the support frame 72 at the printing pressure application height hp to press the squeegee 70 against the board facing area W1 (step S102). Then, based on a printing pressure received by the squeegee 70 pressed against the board facing area W1, the main controller 10 adjusts the height of the board relative to the mask M. By doing so, it becomes possible to adjust the height of the board S appropriately relative to the mask M.

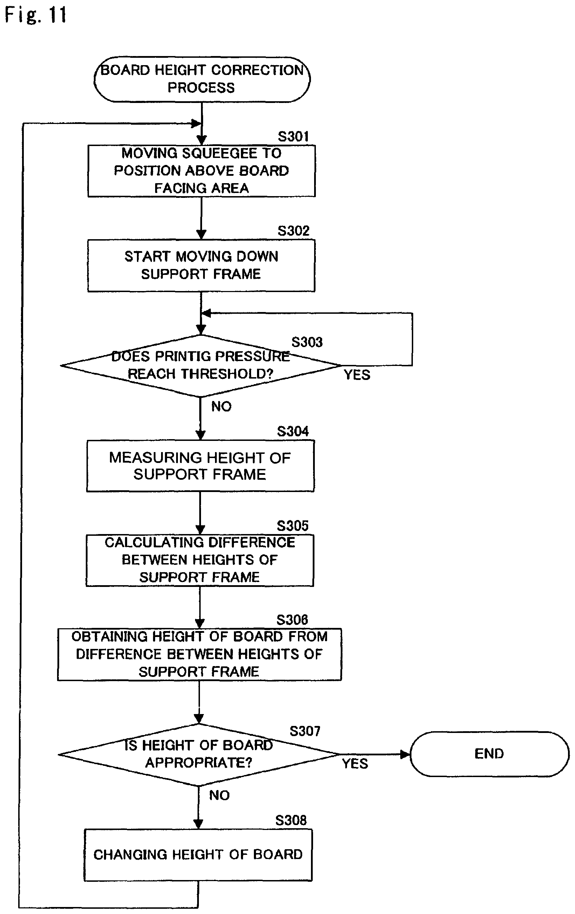

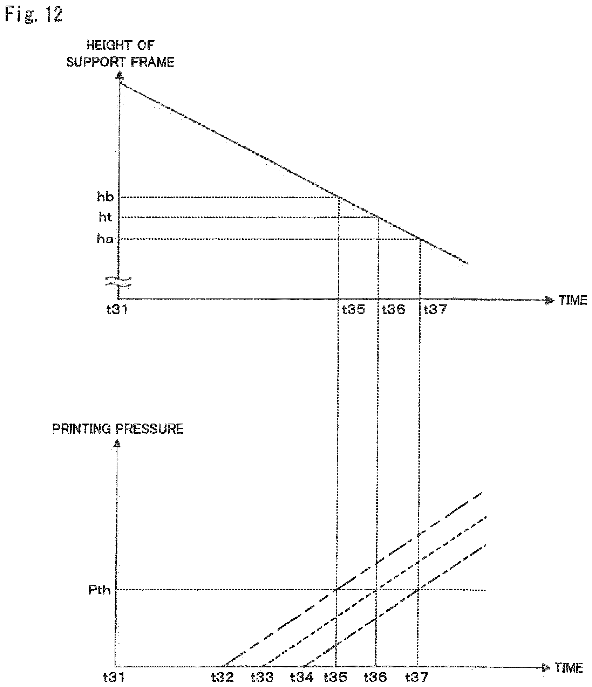

Fig. 11 is a flowchart showing a third non-claimed example of the board height correction process. Fig. 12 is a timing chart schematically showing operation to be performed based on the flowchart of Fig. 10. The following description is mainly intended for differences from the foregoing embodiment. If appropriate, description of common points will be omitted. Meanwhile, it should be noted that, by the presence of configurations common to those of the foregoing embodiment, effects comparable to those of the foregoing embodiment will certainly be achieved.

When the board height correction process is started, the squeegee unit 6 moves the squeegee 70 to a position above the board facing area W1 of the mask M while maintaining the support frame 72 at the initial height ho in step S301 (time t31). While the support frame 72 is at the initial height ho, the tip of the squeegee 70 is separated from and above the board facing area W1 of the mask M. Next, the squeegee unit 6 starts moving down the support frame 72 from the initial height ho (step S302).

While the support frame 72 moves down at a fixed speed, the squeegee 70 is brought into contact with the upper surface of the mask M at some point in time and then starts receiving resistive force from the board S. In this way, a printing pressure on the squeegee 70 starts to increase from zero. At this time, if the position of the mask M and that of the board S are in the relationship shown as the state B3 of Fig. 6, the printing pressure starts to increase at time t33 (indicated by broken lines in the graph of Fig. 12 showing a printing pressure). If the position of the mask M and that of the board S are in the relationship shown as the state B2 of Fig. 6, the printing pressure starts to increase at time t32 before the time t33 (indicated by alternate long and two short dashed lines in the graph of Fig. 12 showing a printing pressure). If the position of the mask M and that of the board S are in the relationship shown as the state B1 of Fig. 6, the printing pressure starts to increase at time t34 after the time t33 (indicated by alternate long and short dashed lines in the graph of Fig. 12 showing a printing pressure).

Then, it is determined whether a printing pressure measured based on a result of detection by the printing pressure sensor 74 has reached a predetermined threshold Pth (step S303). Then, the height of the support frame 72 at a time when the printing pressure has reached the threshold Pth is measured based on output from an encoder of the Z-axis motor M82 (step S304). At this time, if the position of the mask M and that of the board S are in the relationship shown as the state B3 of Fig. 6, the printing pressure reaches the threshold Pth at time t36 (indicated by broken lines in the graph of Fig. 12 showing a printing pressure) and the support frame 72 is located at a reference height ht. If the position of the mask M and that of the board S are in the relationship shown as the state B2 of Fig. 6, the printing pressure reaches the threshold Pth at time t35 before the time t36 (indicated by alternate long and two short dashed lines in the graph of Fig. 12 showing a printing pressure) and the support frame 72 is located at a height hb higher than the reference height ht. If the position of the mask M and that of the board S are in the relationship shown as the state B1 of Fig. 6, the printing pressure reaches the threshold Pth at time t37 after the time t36 (indicated by alternate long and short dashed lines in the graph of Fig. 12 showing a printing pressure) and the support frame 72 is located at a height ha lower than the reference height ht. The support frame 72 stops moving down when the printing pressure reaches the predetermined threshold Pth.

Then, the main controller 10 calculates a difference between the reference height ht stored in advance in the storage 11 and the height of the support frame 72 measured in step S304 (step S305). Based on this difference in height, the main controller 10 determines the height of the upper surface of the board S (step S306). Next, in step S307, the main controller 10 determines the appropriateness of the height of the upper surface of the board S by determining whether the height of the upper surface of the board S is within a predetermined range. If the height of the upper surface of the board S is not within the predetermined range (if "NO" in step S307), the main controller 10 changes the height of the board S (step S308) like in step S109 described above. Step S301 to step S308 are performed repeatedly until the height of the upper surface of the board S is determined to be within the predetermined range in step S307. If the height of the upper surface of the board S is finally determined to be within the predetermined range in step S307, the board height correction process of Fig. 11 is finished.

As described above, in the third example of the board height correction process, detected is also a printing pressure received by the squeegee 70 brought into contact with the board facing area W1 of the upper surface of the mask M to which the board S faces. By the use of correlation between the height of the board S relative to the mask M and a printing pressure acting on the squeegee 70, the height of the board S relative to the mask M is adjusted based on the printing pressure received by the squeegee 70. As a result, the height of the board S can be adjusted appropriately relative to the mask M.

In particular, in the third example of the board height correction process, performed is pressure detecting operation of moving down the squeegee 70 separated from the mask M toward the mask M to be brought into contact with the board facing area W1 (step S302). If the squeegee 70 is moved down toward the mask M to be brought into contact with the board facing area W1, a printing pressure received by the squeegee 70 is changed in a manner that depends on the height of the board S relative to the mask M. In this regard, the main controller 10 adjusts the height of the board S relative to the mask M based on the change in printing pressure received by the squeegee 70 brought into contact with the board facing area W1. By doing so, it becomes possible to adjust the height of the board S appropriately relative to the mask M.

As described above, in this embodiment, the printer 1 corresponds to an example of a "printer" of the present invention. The mask holding unit 2 corresponds to an example of a "mask holder" of the present invention. The mask M corresponds to an example of a "mask" of the present invention. The board holding unit 4 corresponds to an example of a "board driver" of the present invention. The board S corresponds to an example of a "board" of the present invention. The squeegee unit 6 corresponds to an example of a "squeegee driver" of the present invention. The squeegee 70 corresponds to an example of a "squeegee" of the present invention. The printing pressure sensor 74 corresponds to an example of a "pressure detector" of the present invention. A printing pressure corresponds to an example of a "pressure" of the present invention. The main controller 10 corresponds to an example of a "controller" of the present invention. The board facing area W1 corresponds to an example of a "first area" of the present invention. The plate facing area W2 corresponds to an example of a "second area" of the present invention. The support frame 72 corresponds to an example of a "support member" of the present invention. The compression spring 76 corresponds to an example of a "biasing member" of the present invention. The Z-axis motor M82 corresponds to an example of a "driving source" of the present invention. The printing pressure application height hp corresponds to an example of a "predetermined height" of the present invention.

The present invention is not limited to the above-described embodiment. Various changes are applicable to the above-described embodiment within a range not deviating from the scope of the invention. For example, a destination of the downward movement of the support frame 72 in step S102 or S202 is not limited to the printing pressure application height hp but may be a height different from the printing pressure application height hp.

In the foregoing squeegee unit 6, the support frame 72 is arranged above the plate 711 and biasing force is applied to the squeegee 70 using the compression spring 76. Alternatively, the squeegee unit 6 may be configured in such a manner that the support frame 72 is arranged below the plate 711 and biasing force is applied to the squeegee 70 using an extension spring.

Timing of performing the board height correction process has not been described specifically in the embodiment. Meanwhile, the board height correction process can be performed at various timing. For example, each time new solder (paste) is supplied to the upper surface of the mask M, the squeegee unit 6 performs smoothing operation of causing the squeegee 70 to slide on the mask M for spreading the solder along the squeegee 70, where appropriate. The main controller 10 may perform the board height correction process before the implementation of the smoothing operation. This makes it possible to perform the smoothing operation while the height of the board S is adjusted appropriately relative to the mask M. Additionally, the main controller 10 may perform the board height correction process before the implementation of the printing operation. This makes it possible to perform the printing operation while the height of the board S is adjusted appropriately relative to the mask M. Alternatively, the main controller 10 may perform board height correction process each time the printing operation is performed on the boards S of a predetermined number. This makes it possible to perform the subsequent printing operation while the height of the board S is adjusted appropriately relative to the mask M.

### [Industrial Applicability]

The present invention is applicable to every printing technique of printing paste on the upper surface of a mask onto a board by causing a squeegee to slide on the upper surface of the mask overlapping the board from above.

### [REFERNCE SIGNS LIST]

- 1...: printer
- 2...: mask holding unit
- 4...: board holding unit
- 6...: squeegee unit
- 70...: squeegee
- 72...: support frame
- 74...: printing pressure sensor
- 76...: compression spring
- 10...: main controller
- M82...: Z-axis drive
- W1...: board facing area (first area)
- W2...: clamp plate facing area (second area)
- M...: mask
- S...: board
- hp...: printing pressure application height

## Claims

1. A printer (1) comprising:
a mask holder (2) configured to hold a mask (M);
a board driver (4) configured to cause a board (S) to face the mask (M) by driving the board (S) below the mask (M);
a squeegee driver (6) configured to drive a squeegee (70) provided above the mask (M);
a pressure detector (74) configured to detect a pressure received by the squeegee (70); and
wherein
the squeegee driver (6) includes: a support member (72) configured to support the squeegee (70) so as to allow the squeegee (70) to move up and down; a biasing member (76) configured to bias the squeegee (70) downward by generating biasing force between the support member (72) and the squeegee (70), the biasing force changing in response to a difference in height between the support member (72) and the squeegee (70); and a driving source (M82)
configured to move the support member (72) up and down, wherein
the squeegee driver (6) is configured to press the support member (72) downward against the biasing force using the driving source (M82) while the squeegee (70) contacts the mask (M) so as to press the squeegee (70) against the mask (M) with a pressure responsive to the biasing force, the printer (1) further comprises a clamp plate (424) configured to clamp the board (S) facing the mask (M) from a horizontal direction, the squeegee driver (6) is configured to perform pressure detecting operation of locating the support member (72) at a predetermined height (hp) to press the squeegee (70) against a second area (W2) of the upper surface of the mask (M), and then moving the support member (72) parallel to the horizontal direction to cause the squeegee (70) to slide on a first area (W1) of the upper surface of the mask (M) being faced by the board (S), **characterized by** a controller (10) configured to adjust the position of the board (S) relative to the mask (M) in a vertical direction using the board driver (4) based on the pressure detector's detection result of a pressure received by the squeegee (70) brought into contact with the first area (W1) of the upper surface of the mask (M),
the controller (10) being configured to adjust the position of the board (S) relative to the mask (M) in the vertical direction based on the pressure detector's detection result of a pressure received by the squeegee (70) pressed against the first area (W1), the clamp plate (424) being configured to contact the lower surface of the mask (M), the second area (W2) being faced by the clamp plate (424), and
the controller (10) being configured to adjust the position of the board (S) relative to the mask (M) in the vertical direction based on a difference between a pressure received by the squeegee (70) pressed against the second area (W2) and a pressure received by the squeegee (70) sliding on the first area (W1) in the pressure detecting operation.

2. The printer (1) according to claim 1, wherein
the squeegee driver (6) is configured to perform the pressure detecting operation before the implementation of smoothing operation of causing the squeegee (70) to slide on the mask (M) for spreading paste supplied to the upper surface of the mask (M) along the squeegee (70), and
the controller (10) is configured to adjust the position of the board (S) relative to the mask (M) in the vertical direction before the squeegee driver (6) performs the smoothing operation.

3. The printer (1) according to claim 1, wherein
the squeegee driver (6) is configured to perform the pressure detecting operation before the implementation of printing operation of printing solder on the upper surface of the mask (M) onto the board (S) via a hole in the mask (M) by causing the squeegee (70) to slide on the mask (M), and
the controller (10) is configured to adjust the position of the board (S) relative to the mask (M) in the vertical direction before the squeegee driver (6) performs the printing operation.

4. The printer (1) according to claim 1, wherein
the squeegee driver (6) is configured to perform the pressure detecting operation after the implementation of printing operation on the boards (S) of a predetermined number, the printing operation being operation of printing solder on the upper surface of the mask (M) onto the board (S) via a hole in the mask (M) by causing the squeegee (70) to slide on the mask (M), and
the controller (10) is configured to adjust the position of the board (S) relative to the mask (M) in the vertical direction after implementation of the pressure detecting operation.

5. A board position adjusting method comprising:
a step of causing a board (S) to face a mask (M) from below, wherein a clamp plate (424) is configured to clamp the board (S) facing the mask (M) from a horizontal direction;
a step of detecting a pressure received by a squeegee (70) brought into contact with a first area (W1) of the upper surface of the mask (M), the first area (W1) being faced by the board (S), wherein the squeegee (70) is configured to be supported by a support member (72) so as to allow the squeegee (70) to move up and down, the squeegee (70) is configured to be biased by a biasing member (76) downward by generating biasing force between the support member (72) and the squeegee (70), the biasing force is to be changed in response to a difference in height between the support member (72) and the squeegee (70), the support member (72) is configured to be moved up and down by a driving source (M82);
a step of pressing the support member (72) downward against the biasing force using the driving source (M82) while the squeegee (70) contacts the mask (M) so as to press the squeegee (70) against the mask (M) with a pressure responsive to the biasing force; and
a step of performing pressure detecting operation of locating the support member (72) at a predetermined height (hp) to press the squeegee (70) against a second area (W2) of the upper surface of the mask (M), and then moving the support member (72) parallel to the horizontal direction to cause the squeegee (70) to slide on the first area (W1),
**characterized in that**,
in the step of causing the board (S) to face the mask (M) from below, the clamp plate (424) contacts the lower surface of thee mask (M), and by
a step of adjusting the position of the board (S) relative to the mask (M) in a vertical direction based on a difference between a pressure received by the squeegee (70) pressed against the second area (W2) being faced by the clamp plate (424) and a pressure received by the squeegee (70) sliding on the first area (W1) in the pressure detecting operation.

## Patentansprüche

1. Druckvorrichtung (1), aufweisend:
einen Maskenhalter (2), welcher eingerichtet ist, um eine Maske (M) zu halten;
einen Platinenantrieb (4), welcher eingerichtet ist, um eine Platine (S) durch Antreiben der Platine (S) unterhalb der Maske (M) zu veranlassen, der Maske (M) zugewandt zu sein;
einen Rakelantrieb (6), welcher eingerichtet ist, um eine oberhalb der Maske (M) bereitgestellte Rakel (70) anzutreiben;
eine Druckerfassungseinrichtung (74), welche eingerichtet ist, um einen durch die Rakel (70) aufgenommenen Druck zu erfassen; und wobei
der Rakelantrieb (6) aufweist: ein Lagerelement (72), welches eingerichtet ist, um die Rakel (70) so zu lagern, dass es der Rakel (70) ermöglicht ist, sich auf und ab zu bewegen; ein Vorspannelement (76), welches eingerichtet ist, um die Rakel (70) durch Erzeugen einer Vorspannkraft zwischen dem Lagerelement (72) und der Rakel (70) nach unten vorzuspannen, wobei sich die Vorspannkraft als Reaktion auf einen Höhenunterschied zwischen dem Lagerelement (72) und der Rakel (70) verändert; und eine Antriebsquelle (M82), welche eingerichtet ist, um das Lagerelement (72) auf und ab zu bewegen, wobei
der Rakelantrieb (6) eingerichtet ist, um das Lagerelement (72) unter Verwendung der Antriebsquelle (M82) gegen die Vorspannkraft nach unten zu drücken, während die Rakel (70) mit der Maske (M) so in Kontakt steht, dass die Rakel (70) mit einem auf die Vorspannkraft reagierenden Druck gegen die Maske (M) gedrückt wird, die Druckvorrichtung (1) ferner eine Klemmplatte (424) aufweist, welche eingerichtet ist, um die Platine (S), welche der Maske (M) zugewandt ist, von einer horizontalen Richtung aus festzuklemmen, der Rakelantrieb (6) eingerichtet ist, um einen Druckerfassungsvorgang zum Positionieren des Lagerelements (72) in einer vorbestimmten Höhe (hp), um die Rakel (70) gegen einen zweiten Bereich (W2) der Oberfläche der Maske (M) zu drücken, und zum anschließenden Bewegen des Trägerelements (72) parallel zu der horizontalen Richtung, um die Rakel (70) zu veranlassen, auf einem ersten Bereich (W1) der Oberfläche der Maske (M) zu gleiten, welchem die Platine (S) zugewandt ist, durchzuführen, **dadurch gekennzeichnet, dass** ein Controller (10) eingerichtet ist, um unter Verwendung des Platinenantriebs (4) auf Grundlage eines Erfassungsergebnisses der Druckerfassungseinrichtung eines Drucks, welcher durch die Rakel (70) aufgenommen ist, welche mit dem ersten Bereich (W1) der Oberfläche der Maske (M) in Kontakt gebracht ist, die Position der Platine (S) relativ zu der Maske (M) in einer vertikalen Richtung anzupassen,
wobei der Controller (10) eingerichtet ist, um die Position der Platine (S) relativ zu der Maske (M) in der vertikalen Richtung auf Grundlage des Erfassungsergebnisses der Druckerfassungseinrichtung eines Drucks anzupassen, welcher durch die Rakel (70) aufgenommen ist, welche gegen den ersten Bereich (W1) gedrückt ist, die Klemmplatte (424) eingerichtet ist, um mit der Unterfläche der Maske (M) in Kontakt zu stehen, dem zweiten Bereich (W2) der Klemmplatte (424) zugewandt ist und der Controller (10) eingerichtet ist, um auf Grundlage eines Unterschieds zwischen einem Druck, welcher durch die Rakel (70) aufgenommen wird, die gegen den zweiten Bereich (W2) gedrückt ist, und einem Druck, welcher durch die Rakel (70) aufgenommen wird, welche bei dem Druckerfassungsvorgang auf dem ersten Bereich (W1) gleitet, die Position der Platine (S) relativ zu der Maske (M) in der vertikalen Richtung anzupassen.

2. Druckvorrichtung (1) nach Anspruch 1, wobei
der Rakelantrieb (6) eingerichtet ist, um den Druckerfassungsvorgang vor der Implementierung eines Glättungsvorgangs zum Veranlassen der Rakel (70), auf der Maske (M) zum Verteilen einer der Oberfläche der Maske (M) zugeführten Paste entlang der Rakel (70) zu gleiten, durchzuführen, und
der Controller (10) eingerichtet ist, um die Position der Platine (S) relativ zu der Maske (M) in der vertikalen Richtung anzupassen, bevor der Rakelantrieb (6) den Glättungsvorgang durchführt.

3. Druckvorrichtung (1) nach Anspruch 1, wobei
der Rakelantrieb (6) eingerichtet ist, um den Druckerfassungsvorgang vor der Implementierung eines Druckvorgangs zum Drucken einer Lötpaste auf der Oberfläche der Maske (M) auf die Platine (S) mittels eines Lochs in der Maske (M) durch Veranlassen der Rakel (70), auf der Maske (M) zu gleiten, durchzuführen, und
der Controller (10) eingerichtet ist, um die Position der Platine (S) relativ zu der Maske (M) in der vertikalen Richtung anzupassen, bevor der Rakelantrieb (6) den Druckvorgang durchführt.

4. Druckvorrichtung (1) nach Anspruch 1, wobei
der Rakelantrieb (6) eingerichtet ist, um den Druckerfassungsvorgang nach der Implementierung eines Druckvorgangs auf den Platinen (S) einer vorbestimmten Anzahl durchzuführen, wobei der Druckvorgang ein Vorgang zum Drucken einer Lötpaste auf der Oberfläche der Maske (M) auf die Platine (S) mittels eines Lochs in der Maske (M) durch Veranlassen der Rakel (70), auf der Maske (M) zu gleiten, ist, und
der Controller (10) eingerichtet ist, die Position der Platine (S) relativ zu der Maske (M) in der vertikalen Richtung nach Implementierung des Druckerfassungsvorgangs anzupassen.

5. Verfahren zur Anpassung der Position einer Platine, umfassend:
einen Schritt des Veranlassens einer Platine (S), einer Maske (M) von unten her zugewandt zu sein, wobei eine Klemmplatte (424) eingerichtet ist, um die Platine (S), welche der Maske (M) zugewandt ist, von einer horizontalen Richtung aus festzuklemmen; einen Schritt des Erfassens eines Drucks, welcher durch eine Rakel (70) aufgenommen wird, welche mit einem ersten Bereich (W1) der Oberfläche der Maske (M) in Kontakt gebracht wird, wobei dem ersten Bereich (W1) die Platine (S) zugewandt ist, wobei die Rakel (70) eingerichtet ist, um durch ein Lagerelement (72) so gelagert zu werden, dass es der Rakel (70) ermöglicht wird, sich auf und ab zu bewegen, die Rakel (70) eingerichtet ist, um durch ein Vorspannelement (76) durch Erzeugen einer Vorspannkraft zwischen dem Lagerelement (72) und der Rakel (70) nach unten vorgespannt zu werden, die Vorspannkraft als Reaktion auf einen Höhenunterschied zwischen dem Lagerelement (72) und der Rakel (70) zu verändern ist und das Lagerelement (72) eingerichtet ist, um durch eine Antriebsquelle (M82) auf und ab bewegt zu werden;
einen Schritt des Drückens des Lagerelements (72) nach unten gegen die Vorspannkraft unter Verwendung der Antriebsquelle (M82), während die Rakel (70) mit der Maske (70) so in Kontakt steht, dass die Rakel (70) mit einem auf die Vorspannkraft reagierenden Druck gegen die Maske (M) gedrückt wird; und
einen Schritt des Durchführens eines Druckerfassungsvorgangs zum Positionieren des Lagerelements (72) in einer vorbestimmten Höhe (hp), um die Rakel (70) gegen einen zweiten Bereich (W2) der Oberfläche der Maske (M) zu drücken, und zum anschließenden Bewegen des Lagerelements (72) parallel zu der horizontalen Richtung, um die Rakel (70) zu veranlassen, auf dem ersten Bereich (W1) zu gleiten,
**dadurch gekennzeichnet, dass**
die Klemmplatte (424) in dem Schritt des Veranlassens der Platine (S), der Maske (M) von unten her zugewandt zu sein, mit der Unterfläche der Maske (M) in Kontakt steht, und durch einen Schritt des Anpassens der Position der Platine (S) relativ zu der Maske (M) in einer vertikalen Richtung auf Grundlage eines Unterschieds zwischen einem Druck, welcher durch die Rakel (70) aufgenommen wird, welche gegen den zweiten Bereich (W2) gedrückt wird, welchem die Klemmplatte (424) zugewandt ist, und einem Druck, welcher durch die Rakel (70) aufgenommen wird, welche bei dem Druckerfassungsvorgang auf dem ersten Bereich (W1) gleitet.

## Revendications

1. Imprimante (1), comprenant :
un porte-masque (2) conçu pour supporter un masque (M) ;
une unité d'entraînement de carte (4) conçue pour amener la carte (S) à faire face au masque (M) en entraînant la carte (S) sous le masque (M) ;
une unité d'entraînement de raclette (6) conçue pour entraîner une raclette (70) placée au-dessus du masque (M) ;
un détecteur de pression (74) conçu pour détecter une pression reçue par la raclette (70) ; et
dans laquelle
l'unité d'entraînement de raclette (6) comprend : un élément de support (72) conçu pour supporter la raclette (70) de manière à permettre à la raclette (70) de se déplacer vers le haut et le bas ; un élément de sollicitation (76) conçu pour solliciter la raclette (70) vers le bas en générant une force de sollicitation entre l'élément de support (72) et la raclette (70), la force de sollicitation changeant en réponse à une différence de hauteur entre l'élément de support (72) et la raclette (70) ; et une source d'entraînement (M82) conçue pour déplacer l'élément de support (72) vers le haut et le bas, dans laquelle
l'unité d'entraînement de raclette (6) est conçue pour presser l'élément de support (72) vers le bas contre la force de sollicitation en utilisant la source d'entraînement (M82) alors que la raclette (70) entre en contact avec le masque (M) de manière à presser la raclette (70) contre le masque (M) avec une pression répondant à la force de sollicitation, l'imprimante (1) comprend en outre une plaque de serrage (424) conçue pour serrer la carte (S) faisant face au masque (M) depuis une direction horizontale, l'unité d'entraînement de raclette (6) étant conçue pour effectuer une opération de détection de pression de localisation de l'élément de support (72) à une hauteur prédéterminée (hp) pour presser la raclette (70) contre une seconde région (W2) de la surface supérieure du masque (M), et ensuite déplacer l'élément de support (72) parallèlement à la direction horizontale pour amener la raclette (70) à glisser sur une première région (W1) de la surface supérieure du masque (M) faisant face à la carte (S), **caractérisée par** une unité de commande (10) conçue pour régler la position de la carte (S) par rapport au masque (M) dans une direction verticale en utilisant l'unité d'entraînement de la carte (4) sur la base du résultat de détection du détecteur d'une pression reçue par la raclette (70) mise en contact avec la première région (W1) de la surface supérieure du masque (M), l'unité de commande (10) étant conçue pour régler la position de la carte (S) par rapport au masque (M) dans la direction verticale sur la base du résultat de détection du détecteur d'une pression reçue par la raclette (70) pressée contre la première région (W1), la plaque de serrage (424) étant conçue pour entrer en contact avec la surface inférieure du masque (M), la seconde région (W2) faisant face à la plaque de serrage (424), et
l'unité de commande (10) étant conçue pour régler la position de la carte (S) par rapport au masque (M) dans la direction verticale sur la base d'une différence entre une pression reçue par la raclette (70) pressée contre la seconde région (W2) et une pression reçue par la raclette (70) glissant sur la première région (W1) dans l'opération de détection de pression.

2. Imprimante (1) selon la revendication 1, dans laquelle :
l'unité d'entraînement de raclette (6) est conçue pour effectuer l'opération de détection de pression avant la mise en œuvre d'une opération de lissage amenant la raclette (70) à glisser sur le masque (M) pour étendre une pâte fournie sur la surface supérieure du masque (70) le long de la raclette (70), et
l'unité de commande (10) est conçue pour régler la position de la carte (S) par rapport au masque (M) dans la direction verticale avant que l'unité d'entraînement de raclette (6) effectue l'opération de lissage.

3. Imprimante (1) selon la revendication 1, dans laquelle :
l'unité d'entraînement de raclette (6) est conçue pour effectuer l'opération de détection de pression avant la mise en œuvre d'une opération d'impression de la soudure sur la surface supérieure du masque (M) sur la carte (S) par un trou dans le masque (M) en amenant la raclette (70) à glisser sur le masque (M), et
l'unité de commande (10) est conçue pour régler la position de la carte (S) par rapport au masque (M) dans la direction verticale avant que l'unité d'entraînement de raclette (6) effectue l'opération d'impression.

4. Imprimante (1) selon la revendication 1, dans laquelle :
l'unité d'entraînement de raclette (6) est conçue pour effectuer l'opération de détection de pression après la mise en œuvre d'une opération d'impression sur les cartes (S) d'un nombre prédéterminé, l'opération d'impression étant une opération d'impression de soudure sur la surface supérieure du masque (M) sur la carte (S) par un trou dans le masque (M) en amenant la raclette (70) à glisser sur le masque (M), et
l'unité de commande (10) est conçue pour régler la position de la carte (S) par rapport au masque (M) dans la direction verticale après la mise en œuvre de l'opération de détection de pression.

5. Procédé de réglage de la position d'une carte comprenant :
une étape consistant à amener une carte (S) à faire face à un masque (M) depuis le bas, dans lequel une plaque de serrage (424) est conçue pour serrer la carte (S) faisant face au masque (M) depuis une direction horizontale ;
une étape de détection d'une pression reçue par une raclette (70) mise en contact avec une première région (W1) de la surface supérieure du masque (M), la carte (S) faisant face à la première région (W1), dans lequel la raclette (70) est conçue pour être supportée par un élément de support (72) de manière à permettre à la raclette (70) de se déplacer vers le haut et le bas, la raclette (70) étant conçue pour être sollicitée par un élément de sollicitation (76) vers le bas en générant une force de sollicitation entre l'élément de support (72) et la raclette (70), la force de sollicitation devant être changée en réponse à une différence de hauteur entre l'élément de support (72) et la raclette (70), l'élément de support (72) étant conçue pour être déplacé vers le haut et le bas par une source d'entraînement (M82) ;
une étape de pressage de l'élément de support (72) vers le bas contre la force de sollicitation en utilisant la source d'entraînement (M82) alors que la raclette (70) entre en contact avec le masque (M) de manière à presser la raclette (70) contre le masque (M) avec une pression répondant à la force de sollicitation ; et
une étape de réalisation d'une opération de détection de pression de localisation de l'élément de support (72) à une hauteur prédéterminée (hp) pour presser la raclette (70) contre une seconde région (W2) de la surface supérieure du masque (M), et ensuite déplacer l'élément de support (72) parallèlement à la direction horizontale pour amener la raclette (70) à glisser sur la première région (W1),
**caractérisé en ce que**, dans l'étape d'amener la carte (S) à faire face au masque (M) depuis le bas, la plaque de serrage (424) entre en contact avec la surface inférieure du masque (M), et par
une étape de réglage de la position de la carte (S) par rapport au masque (M) dans une direction verticale sur la base d'une différence entre une pression reçue par la raclette (70) pressée contre la seconde région (W2) faisant face à la plaque de serrage (424) et une pression reçue par la raclette (70) glissant sur la première région (W1) dans l'opération de détection de pression.
